# EUROPÄISCHE PATENTSCHRIFT

(11) **EP 3 120 301 B1**
(45) Veröffentlichungstag und Bekanntmachung des Hinweises auf die Patenterteilung: **10.07.2019**
(21) Anmeldenummer: 15704720.0
(22) Anmeldetag: 11.02.2015
(51) Int. Cl.: G06K 19/077, H01L 23/14, H01L 23/498

(54) **VERFAHREN ZUR HERSTELLUNG EINES CHIPMODULS**
METHOD FOR PRODUCING A CHIP MODULE
PROCÉDÉ DE FABRICATION D'UN MODULE À PUCE ÉLECTRONIQUE

(30) Priorität: 19.03.2014 DE 102014003989
(43) Veröffentlichungstag der Anmeldung: 25.01.2017
(73) Patentinhaber: Giesecke+Devrient Mobile Security GmbH, 81677 München (DE)
(72) Erfinder: TARANTINO, Thomas, 83410 Laufen (DE)
(86) Internationale Anmeldenummer: PCT/EP2015/000302
(87) Internationale Veröffentlichungsnummer: WO 2015/139801

(56) Entgegenhaltungen:
- EP-A1- 0 772 232
- DE-A1-102007 036 838
- JP-A- H03 142 294

## Beschreibung

Die Erfindung beschreibt ein Chipmodul, welches für die Herstellung von tragbaren Datenträgern mit Chipmodul, wie z.B. Chipkarten, Kreditkarten, SIM-Karten, Gesundheitskarten, Ausweisen, Führerscheinen verwendet wird. Ferner beschreibt die Erfindung ein Verfahren zur Herstellung eines tragbaren Datenträgers mittels eines erfindungsgemäßen Chipmoduls

Aus dem Stand der Technik sind Verfahren zur Herstellung von tragbaren Datenträgern mit einem Chipmodul bekannt, z.B. Verfahren zur Herstellung von Smart Cards. Die Chipmodule werden in der Regel in eine Vertiefung eines Kartenkörpers des tragbaren Datenträgers eingesetzt. Das Chipmodul wird z.B. mittels eines hitzeaktivierbaren Klebstoffs mit dem Kartenkörper verbunden. Anschließend wird der Klebstoff durch Aufbringung von Druck und Wärme ausgehärtet. Problematisch ist, dass dabei ein Chip des Chipmoduls einer thermischen Belastung ausgesetzt wird. Ferner ist die Verbindung zwischen Chipmodul und Kartenkörper häufig nicht ausgehärtet, sondern flexibel und wieder lösbar.

EP 0 772 232 A1 offenbart ein Verfahren zur Herstellung eines Chipmoduls, welches einen Träger aufweist, auf dessen einer Seite Kontakte angeordnet sind, die mit einem Chip elektrisch leitend verbunden sind, wobei der Chip sich auf der gegenüberliegenden Seite des Trägers befindet.

Ausgehend vom Stand der Technik ist es Aufgabe der Erfindung eine Lösung zu finden, welche die beschriebenen Nachteile vermeidet.

Die Aufgabe der Erfindung wird durch den unabhängigen Anspruch gelöst. Vorteilhafte Ausführungen sind in den abhängigen Ansprüchen beschrieben.

Zur Lösung der Aufgabe offenbart die Erfindung ein Chipmodul, welches in einen Kartenkörper eines tragbaren Datenträgers eingesetzt und mit diesem unlösbar verbunden wird, wobei das Modul einen Träger umfasst, wobei mindestens ein elektrisch leitfähiger Kontakt auf einer Seite des Trägers angeordnet ist, wobei auf einer anderen Seite des Trägers, welcher der Seite gegenüberliegend angeordnet ist, auf welcher der mindestens eine Kontakt angeordnet ist, mindestens ein Chip angeordnet ist, wobei der Chip mindestens einen Anschluss aufweist, welcher mit mindestens einem Kontakt elektrisch leitend verbunden ist, wobei sich das Chipmodul dadurch auszeichnet, dass der Träger mindestens einen ersten Bereich aufweist, der für Laserlicht durchlässig ist, und mindestens einen zweiten Bereich aufweist, der für Laserlicht nicht durchlässig ist. Mit dem erfindungsgemäßen Chipmodul ist eine schnellere Herstellung von tragbaren Datenträgern als mit üblichen Chipmodulen gemäß dem Stand der Technik möglich. Ferner wird eine thermische Belastung des Chips im erfindungsgemäßen Chipmodul während der Herstellung der Verbindung zwischen Chipmodul und Kartenkörper im Vergleich zu herkömmlichen Verfahren, wie z.B. Laminierung mittels Druck und Wärme deutlich reduziert. Schließlich ermöglicht das erfindungsgemäße Chipmodul beim Einbau in einen Kartenkörper eines Datenträgers eine unlösbare Verbindung zwischen Chipmodul und Kartenkörper.

Ein vorteilhaftes Ausführungsbeispiel ist, dass der Träger aus mindestens zwei verschiedenen Materialien besteht. Beispielsweise ist das erste Material eine flexible Leiterplatte, die aus Epoxidharz und einem Glasfasergewebe besteht, ein sogenanntes FR4 Material. Das zweite Material ist ein Polyimid, sogenanntes PI, oder ein Polycarbonat, sogenanntes PC, die beide für Infrarotlicht durchlässig sind.

Ein weiteres vorteilhaftes Ausführungsbeispiel ist, dass der Träger aus mindestens zwei Schichten besteht. Durch die geeignete Wahl der Schichten bzw. deren Form und Anzahl können gezielt z. B. mechanische Eigenschaften des Chipmoduls beeinflusst werden.

Ein weiteres vorteilhaftes Ausführungsbeispiel ist, dass die mindestens zwei Schichten des Trägers horizontal und/oder vertikal angeordnet sind. Ferner ist jede andere geeignete Anordnung der Schichten möglich, um den spezifischen mechanischen Anforderungen eines Chipmodules hinsichtlich z.B. Elastizität zu genügen.

Ein weiteres vorteilhaftes Ausführungsbeispiel ist, dass der mindestens eine Kontakt der ISO 7816 entspricht. Neben der ISO 7816 können beliebige andere Normen hinsichtlich der Anordnung von Kontakten verwendet werden. Auch eine beliebige Anordnung von Kontakten ist prinzipiell möglich.

Ferner offenbart die Erfindung zur Lösung der Aufgabe ein Verfahren zur Herstellung eines tragbaren Datenträgers, wobei ein oben beschriebenes Chipmodul in eine Vertiefung eines Kartenkörpers des tragbaren Datenträgers eingesetzt wird, so dass der mindestens eine Kontakt von einer Außenseite des Datenträgers zugänglich ist, welches sich dadurch auszeichnet, dass mindestens ein Bereich des Chipmoduls, der für Laserlicht durchlässig ist, den Kartenkörper berührt, wobei mindestens ein Laserstrahl mindestens eines Lasers den Bereich des Chipmoduls, der für Laserlicht durchlässig ist, durchdringt und das Chipmodul mit dem Kartenkörper an einer Stelle dauerhaft verbindet, z.B. verschweißt, wo sich der Bereich des Chipmoduls, der für Laserlicht durchlässig ist, und der Kartenkörper berühren, wobei der Kartenkörper zumindest an der Stelle, wo sich Chipkarte und Kartenkörper berühren, eine Laserlicht absorbierende Eigenschaft aufweist. Mit dem erfindungsgemäßen Verfahren ist eine schnellere Herstellung von tragbaren Datenträgern mit mindestens einem eingesetzten Chipmodul als mit üblichen Verfahren möglich. Ferner wird eine thermische Belastung des Chips im Chipmodul durch das Verfahren reduziert. Schließlich ermöglicht das erfindungsgemäße Verfahren beim Einbau des erfindungsgemäßen Chipmoduls in einen Kartenkörper eines Datenträgers eine unlösbare Verbindung zwischen erfindungsgemäßen Chipmodul und Kartenkörper.

Ein vorteilhaftes Ausführungsbeispiel ist, dass das Chipmodul und der Kartenkörper jeweils von einer Rolle für das Verfahren zur Verfügung gestellt und verarbeitet werden.

Ein weiteres vorteilhaftes Ausführungsbeispiel ist, dass nach Verschweißen des Chipmoduls mit dem Kartenkörper der erfindungsgemäß hergestellte Datenträger auf eine Rolle zur Weiterverarbeitung aufgebracht wird.

Das Zuführen von Bauelementen, z.B. Chipmodul, Kartenkörper, von einer Rolle und das Abführen z.B. des erfindungsgemäß hergestellten Datenträgers, nach dem Herstellungsverfahren auf eine Rolle mittels eines Bands, auf dem z.B. das Chipmodul, der Kartenkörper oder der Datenträger angeordnet sind, ermöglicht ein sehr schnelles Herstellungsverfahren von tragbaren Datenträgern. Das Band wird dazu entweder von einer Rolle abgewickelt oder wieder auf eine Rolle aufgewickelt.

Alternativ zur Weiterverarbeitung kann z.B. der Datenträger nach der Herstellung auch aus dem Band ausgestanzt und vereinzelt werden.

Im Folgenden wird ein Ausführungsbeispiel der Erfindung anhand der beigefügten Figuren beschrieben.
Figur 1 zeigt eine Draufsicht eines erfindungsgemäßen Chipmoduls.
Figur 2 zeigt eine Seitenansicht des Chipmoduls.
Figur 3 zeigt eine Seitenansicht des Chipmoduls, bevor es in einen Kartenkörper eines tragbaren Datenträgers eingesetzt wird.
Figur 4 zeigt eine Seitenansicht des in den Kartenkörper eingesetzten erfindungsgemäßen Chipmoduls während der Herstellung einer Verbindung zwischen dem Chipmodul und dem Kartenkörper mittels eines Lasers.

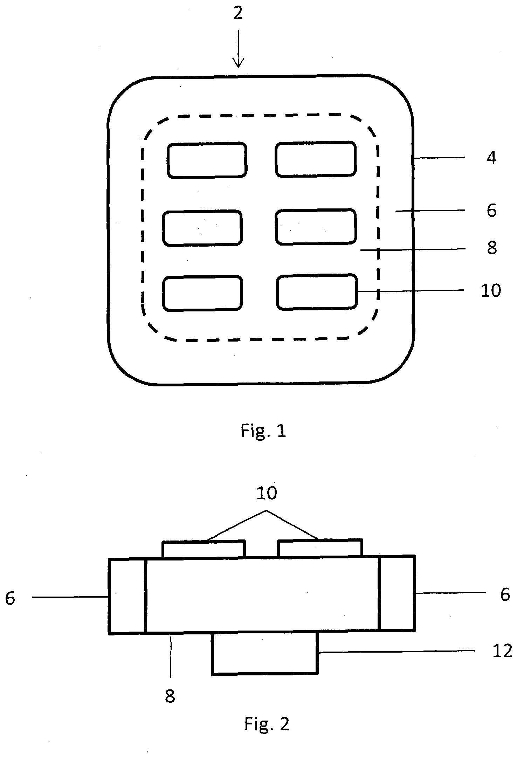

Die Figuren 1 und 2 zeigen ein erfindungsgemäßes Chipmodul 2 in Drauf- und Seitenansicht. Das Chipmodul 2 besteht aus einem Träger 4, wobei der Träger 4 aus mindestens einem ersten und mindestens einem zweiten Bereich 6, 8 besteht. Auf einer Seite des Trägers 4 ist mindestens ein elektrisch leitfähiger Kontakt 10, z.B. bestehend aus Metall, angeordnet. In Figur 1 sind beispielsweise sechs Kontakte 10 angeordnet. Der mindestens eine Kontakt 10 entspricht z.B. der ISO 7816. Der mindestens eine Kontakt 10 kann jeder anderen geeigneten Norm entsprechen, bzw. jede geeignete Anzahl und Form und Anordnung von Kontakten 10 aufweisen. Auf einer dem mindestens einen Kontakt 10 gegenüberliegenden Seite des Trägers 4 ist mindestens ein Chip 12 angeordnet. Der Chip 12 weist mindestens einen Anschluss auf, mittels dessen der Chip 12 mit mindestens einem Kontakt 10 elektrisch leitend verbunden ist, wobei der mindestens eine Anschluss des Chips 12 und eine elektrisch leitende Verbindung zu mindestens einem Kontakt 10 aus Gründen der Übersichtlichkeit nicht dargestellt wurden.

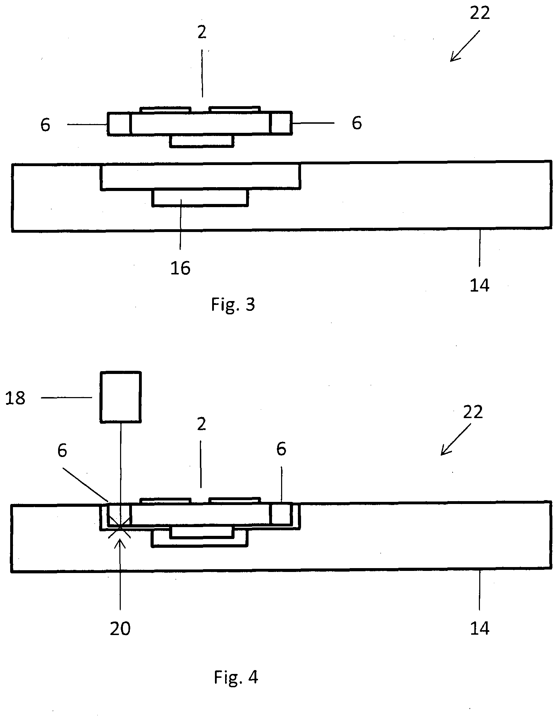

Erfindungswesentlich ist, dass mindestens ein Bereich 6, 8 des Trägers 4 aus einem Material besteht, das für Laserlicht durchlässig ist. Grundsätzlich können alle Bereiche 6, 8 oder nur ein Teil der Bereiche 6, 8 aus einem Material bestehen, das durchlässig für Laserlicht ist. Die äußere Form der Bereiche 6, 8 sind in der Figur 1 nur beispielhaft dargestellt. Es können auch andere Geometrien realisiert werden. Das für Laserlicht durchlässige Material ist wichtig, um das Chipmodul 2 mit einem Kartenkörper 14 mittels Laser 18 zu verschweißen, wie es in Figur 4 beschrieben wird. Beispielsweise ist im Rahmen dieser Beschreibung der erste Bereich 6 der für Laserlicht durchlässige Bereich. Grundsätzlich kann der für Laserlicht durchlässige Bereich, wie in der Figur 1 dargestellt, eine durchgehende Fläche sein oder von nicht Laserlicht durchlässigen Bereichen unterbrochen sein. Der zweite Bereich 8 ist im Rahmen der Beschreibung für Laserlicht nicht durchlässig. Der Träger 4 wird vorzugsweise aus einem bandförmigen Material ausgestanzt. Ferner kann der Träger 4 aus mindestens zwei verschiedenen Schichten von unterschiedlichen Materialien bestehen.

Figur 3 zeigt eine Seitenansicht des Chipmoduls 2, bevor es in einen Kartenkörper 14 eines tragbaren Datenträgers 22 eingesetzt wird. Der Kartenkörper 14 weist eine Vertiefung 16 auf, in die das Chipmodul 2 eingesetzt wird.

Figur 4 zeigt eine Seitenansicht des in den Kartenkörper 14 eingesetzten Chipmoduls 2 während der Herstellung einer Verbindung zwischen dem Chipmodul 2 und dem Kartenkörper 14 mittels eines Lasers 18. Beispielsweise durchdringt ein Strahl des Lasers 18 das Chipmodul 2 im Bereich 6, der für Laserlicht durchlässig ist, um an einer Stelle 20 eine Verbindung mittels Schweißen zwischen dem Chipmodul 2 und dem Kartenkörper 14 herzustellen. Wesentlich für die Erfindung ist, dass an der Stelle 20, wo eine Verbindung zwischen Chipmodul 2 und dem Kartenkörper 14 hergestellt wird, der für das Laserlicht durchlässige Bereich 6 des Chipmoduls 2 den Kartenkörper 14 berührt. Der Kartenkörper 14 weist zumindest an der Stelle 20 eine Laserlicht absorbierende Eigenschaft auf. Eine Verbindung zwischen dem Chipmodul 2 und dem Kartenkörper 14 kann an mindestens einer Stelle 20 hergestellt werden. Die Anzahl der Stellen 20 erhöht die mechanische Belastbarkeit der Verbindung zwischen Chipmodul 2 und Kartenkörper 14. Ferner kann mindestens ein Strahl mindestens eines Lasers 18 verwendet werden.

Die vorliegende Erfindung offenbart ein schnelles Herstellungsverfahren, bei dem das Chipmodul 2, insbesondere der Chip 12, und der Kartenkörper 14 einer niedrigen Temperaturbelastung ausgesetzt sind. Veränderungen des optischen Erscheinungsbilds des Kartenkörpers 14 durch eine erhöhte Wärmeeinwirkung werden wirkungsvoll vermieden. Darüber hinaus wird eine deutlich verbesserte mechanische Festigkeit der Verbindung zwischen Chipmodul 2 und Kartenkörper 14 erreicht.

### Bezugszeichenliste

- 2: erfindungsgemäßes Chipmodul
- 4: Träger
- 6: Erster Bereich des Trägers, der für Laserlicht durchlässig ist
- 8: Zweiter Bereich des Trägers, der für Laserlicht nicht durchlässig ist
- 10: elektrisch leitfähiger Kontakt
- 12: Chip
- 14: Kartenkörper
- 16: Vertiefung des Kartenkörpers
- 18: Laser
- 20: Stelle, an der das Chipmodul den Kartenkörper berührt und mit ihm verschweißt wird
- 22: tragbarer Datenträger

## Patentansprüche

1. Chipmodul (2), welches in einen Kartenkörper (14) eines tragbaren Datenträgers (22) eingesetzt und mit diesem unlösbar verbunden wird,
wobei das Modul (2) einen Träger (4) umfasst,
wobei mindestens ein elektrisch leitfähiger Kontakt (10) auf einer Seite des Trägers (4) angeordnet ist,
wobei auf einer anderen Seite des Trägers (4), welcher der Seite gegenüberliegend angeordnet ist, auf welcher der mindestens eine Kontakt (10) angeordnet ist, mindestens ein Chip (12) angeordnet ist,
wobei der Chip (12) mindestens einen Anschluss aufweist, welcher mit mindestens einem Kontakt (10) elektrisch leitend verbunden ist,
**dadurch gekennzeichnet, dass**
der Träger (4) mindestens einen ersten Bereich (6) aufweist, der für Laserlicht durchlässig ist, und mindestens einen zweiten Bereich (8) aufweist, der für Laserlicht nicht durchlässig ist,
wobei der Bereich (6) des Chipmoduls (2), der für Laserlicht durchlässig ist, den Kartenkörper (14) berührt, um das Chipmodul (2) mit dem Kartenkörper (14) mittels Laser zu verschweißen,
wobei das Chipmodul (2) mit dem Kartenkörper (14) an einer Stelle (20) verschweißt ist, wo sich der Bereich (6) des Chipmoduls (2), der für Laserlicht durchlässig ist, und der Kartenkörper (14) berühren,
wobei der Kartenkörper (14) zumindest an der Stelle (20) eine Laserlicht absorbierende Eigenschaft aufweist.

2. Chipmodul (2) nach Anspruch 1, **dadurch gekennzeichnet, dass** der Träger (4) aus mindestens zwei verschiedenen Materialien besteht.

3. Chipmodul (2) nach Anspruch 2, **dadurch gekennzeichnet, dass** der Träger (4) aus mindestens zwei Schichten besteht.

4. Chipmodul (2) nach Anspruch 3, **dadurch gekennzeichnet, dass** die mindestens zwei Schichten des Trägers (4) horizontal und/oder vertikal angeordnet sind.

5. Chipmodul (2) nach einem der Ansprüche 1 bis 4, **dadurch gekennzeichnet, dass** der mindestens eine Kontakt (10) der ISO 7816 entspricht.

6. Verfahren zur Herstellung eines tragbaren Datenträgers (22), wobei ein Chipmodul (2) gemäß den Ansprüchen 1 bis 5 in eine Vertiefung (16) eines Kartenkörpers (14) des tragbaren Datenträgers (22) eingesetzt wird, so dass der mindestens eine Kontakt (10) von einer Außenseite des Datenträgers (22) zugänglich ist,
**dadurch gekennzeichnet, dass**
mindestens ein Bereich (6) des Chipmoduls (2), der für Laserlicht durchlässig ist, den Kartenkörper (14) berührt,
wobei mindestens ein Laserstrahl mindestens eines Lasers (18) den Bereich (6) des Chipmoduls (2), der für Laserlicht durchlässig ist, durchdringt und das Chipmodul (2) mit dem Kartenkörper (14) an einer Stelle (20) verschweißt, wo sich der Bereich (6) des Chipmoduls (2), der für Laserlicht durchlässig ist, und der Kartenkörper (14) berühren,
wobei der Kartenkörper (14) zumindest an der Stelle (20) eine Laserlicht absorbierende Eigenschaft aufweist.

7. Verfahren nach Anspruch 6, **dadurch gekennzeichnet, dass** das Chipmodul (2) und der Kartenkörper (14) jeweils von einer Rolle für das Verfahren zur Verfügung gestellt und verarbeitet werden.

8. Verfahren nach Anspruch 6 oder 7, **dadurch gekennzeichnet, dass** nach Verschweißen des Chipmoduls (2) mit dem Kartenkörper (14) der erfindungsgemäß hergestellte Datenträger (22) auf eine Rolle zur Weiterverarbeitung aufgebracht wird.

## Claims

1. A chip module (2) which is inserted into a card body (14) of a portable data carrier (22) and is non-detachably connected thereto,
the module (2) comprising a carrier (4),
at least one electrically conductive contact (10) being arranged on one side of the carrier (4),
at least one chip (12) being arranged on another side of the carrier (4) which is arranged opposite the side on which the at least one contact (10) is arranged,
the chip (12) having at least one terminal which is electroconductively connected to at least one contact (10),
**characterized in that**
the carrier (4) has at least one first region (6) which is transparent to laser light and at least one second region (8) which is non-transparent to laser light,
the region (6) of the chip module (2) which is transparent to laser light contacting the card body (14) so as to weld the chip module (2) to the card body (14) by means of laser,
the chip module (2) being welded to the card body (14) at a position (20) where the region (6) of the chip module (2) which is transparent to laser light and the card body (14) are in contact,
the card body (14) having a laser-light absorbing property at least at the position (20).

2. The chip module (2) according to claim 1, **characterized in that** the carrier (4) consists of at least two different materials.

3. The chip module (2) according to claim 2, **characterized in that** the carrier (4) consists of at least two layers.

4. The chip module (2) according to claim 3, **characterized in that** the at least two layers of the carrier (4) are arranged horizontally and/or vertically.

5. The chip module (2) according to any of claims 1 to 4, **characterized in that** the at least one contact (10) corresponds to ISO 7816.

6. A method for manufacturing a portable data carrier (22), wherein a chip module (2) in accordance with the claims 1 to 5 is inserted into a depression (16) of a card body (14) of the portable data carrier (22), so that the at least one contact (10) is accessible from an outer side of the data carrier (22),
**characterized in that**
at least one region (6) of the chip module (2) which is transparent to laser light contacts the card body (14),
at least one laser beam of at least one laser (18) penetrating the region (6) of the chip module (2) which is transparent to laser light and welding the chip module (2) to the card body (14) at a position (20) where the region (6) of the chip module (2) which is transparent to laser light and the card body (14) are in contact,
the card body (14) having a laser-light absorbing property at least at the position (20).

7. The method according to claim 6, **characterized in that** the chip module (2) and the card body (14), for the method, are respectively supplied and processed from a roll.

8. The method according to claim 6 or 7, **characterized in that**, after the chip module (2) has been welded to the card body (14), the data carrier (22) manufactured according to the invention is applied onto a roll for further processing.

## Revendications

1. Module puce (2) qui est inséré dans un corps de carte (14) d'un support de données (22) portable et joint à ce dernier de manière inamovible,
cependant que le module (2) comprend un support (4),
cependant qu'au moins un contact (10) électriquement conducteur est agencé sur une face du support (4),
cependant que, sur une autre face du support (4) opposée à la face sur laquelle le au moins un contact (10) est agencé, au moins une puce (12) est agencée,
cependant que la puce (12) comporte au moins une borne reliée de manière électriquement conductrice à au moins un contact (10),
**caractérisé en ce que**
le support (4) comporte au moins une première zone (6) perméable à la lumière laser, et au moins une deuxième zone (8) non perméable à la lumière laser,
cependant que la zone (6) du module puce (2) perméable à la lumière laser est en attouchement avec le corps de carte (14) afin de souder le module puce (2) au corps de carte (14) au moyen de laser,
cependant que le module puce (2) est soudé au corps de carte (14) à un endroit (20) où la zone (6) du module puce (2) perméable à la lumière laser et le corps de carte (14) se touchent,
cependant que le corps de carte (14) possède au moins à l'endroit (20) une propriété d'absorption de lumière laser.

2. Module puce (2) selon la revendication 1, **caractérisé en ce que** le support (4) consiste en au moins deux matériaux différents.

3. Module puce (2) selon la revendication 2, **caractérisé en ce que** le support (4) consiste en au moins deux couches.

4. Module puce (2) selon la revendication 3, **caractérisé en ce que** les au moins deux couches du support (4) sont agencées horizontalement et/ou verticalement.

5. Module puce (2) selon une des revendications de 1 à 4, **caractérisé en ce que** le au moins un contact (10) est conforme à ISO 7816.

6. Procédé de fabrication d'un support de données (22) portable, cependant qu'un module puce (2) selon les revendications de 1 à 5 est inséré dans un renfoncement (16) d'un corps de carte (14) du support de données (22) portable, de telle façon que le au moins un contact (10) est accessible depuis une face extérieure du support de données (22) portable,
**caractérisé en ce que**
au moins une zone (6), du module puce (2), perméable à la lumière laser, est en attouchement avec le corps de carte (14),
cependant qu'au moins un faisceau laser d'au moins un laser (18) pénètre la zone (6), du module puce (2), perméable à la lumière laser, et que le module puce (2) se soude au corps de carte (14) à un endroit (20) où la zone (6), du module puce (2), perméable à la lumière laser et le corps de carte (14) se touchent,
cependant que le corps de carte (14) possède au moins à l'endroit (20) une propriété d'absorption de lumière laser.

7. Procédé selon la revendication 6, **caractérisé en ce que** c'est respectivement par un rouleau que le module puce (2) et le corps de carte (14) sont mis à disposition pour le procédé et traités.

8. Procédé selon la revendication 6 ou 7, **caractérisé en ce que**, après soudage du module puce (2) au corps de carte (14), le support de données (22) fabriqué selon l'invention est appliqué sur un rouleau afin d'être traité subséquemment.
